# EUROPEAN PATENT APPLICATION

(11) **EP 1 149 932 A2**
(43) Date of publication of application: **31.10.2001**
(21) Application number: 01300556.6
(22) Date of filing: 22.01.2001
(51) Int. Cl.: C23C 16/26, C01B 31/02, C23C 16/48, C23C 16/458, C23C 16/02

(54) **Thermal chemical vapor deposition apparatus and method of synthesizing carbon nanotubes using the same**

(30) Priority: 26.01.2000 KR 2000003613; 21.03.2000 KR 2000014247
(71) Applicant: Iljin Nanotech Co., Ltd., Seoul (KR); Lee, Cheol-jin, Gunsan-city, Jeonlabuk-do (KR)
(72) Inventor: Lee, Cheol-Jin, Gunsan-City, Jeonlabuk-do (KR); Yoo, Jae-Eun, Seongbuk-gu, Seoul (KR)
(74) Representative: Stuttard, Garry Philip

(57) **Abstract**

A thermal chemical vapor deposition apparatus and method of synthesizing carbon nanotubes using the same are provided. The apparatus includes a conveyer conveyer belt for sequentially receiving and conveying a plurality of substrates, a rotating unit for conveying the conveyer belt, a loading unit for sequentially loading the substrates onto the conveyer belt, an unloading unit installed to face the loading unit for unloading the substrates conveyed by the conveyer belt, a reactive gas supplying unit for supplying a reactive gas for synthesizing carbon nanotubes onto the substrates conveyed by the conveyer belt, a substrate heating unit for heating the substrates loaded on the conveyer belt, for thermal reaction of the reactive gas, and an exhausting unit for exhausting a reaction product gas.

## Description

### BACKGROUND OF THE INVENTION

### 1. Field of the Invention

The present invention relates to the synthesis of carbon nanotubes synthesis, and more particularly, to a thermal chemical vapor deposition apparatus and method of synthesizing carbon nanotubes using the same, by which carbon nanotubes can be synthesized on a large-sized substrate with a mass production.

### 2. Description of the Related Art

Carbon nanotubes, each carbon atom is bound to three neighboring carbon atoms to form a flat plane of repeating hexagonal rings resembling a honeycomb, which is rolled to form a cylinder or tube.

In general, the diameter of carbon nanotubes is several Å through several tens of nm, and their length is several tens to several thousands of times greater than their diameter. Carbon nanotubes have characteristics of an electrical conductor (as armchair structure) such as metal, or semiconductor characteristics (as zigzag structure) according to their structure. Also, carbon nanotubes are classified as single-wall nanotubes, or multi-wall nanotubes, or rope nanotubes, according to their form. Since carbon nanotubes have been regarded as a material having excellent electrical characteristics, mechanical strength, and chemical stability, their applicability in many high-technology industries is highly promising.

Recently, methods of synthesizing carbon nanotubes have been suggested, and apparatuses for implementing the methods have been presented. For example, an arc discharge system, a laser evaporation system, a thermal chemical vapor deposition system, and a plasma chemical vapor deposition system have been presented. Among these, the thermal chemical vapor deposition system is being used in synthesizing the carbon nanotubes on a substrate by loading the substrate into a quartz tube containing a reactive gas at a high temperature, thereby causing a carbon nanotube forming reaction.

### SUMMARY OF THE INVENTION

To solve the above problems, it is a first feature of the present invention to provide a thermal chemical vapor deposition apparatus used in sequentially synthesizing carbon nanotubes on a plurality of large-sized substrates.

It is a second feature of the present invention to provide a method of synthesizing carbon nanotubes on a plurality of large-sized substrates using the apparatus of thermal chemical vapor deposition.

Accordingly, to achieve the first feature, there is provided a thermal chemical vapor deposition apparatus including a conveyer belt for sequentially receiving and conveying a plurality of substrates, a rotating unit for conveying the conveyer belt, a loading unit for sequentially loading the substrates onto the conveyer belt, an unloading unit installed to face the loading unit for unloading the substrates conveyed by the conveyer belt, a reactive gas supplying unit for supplying a reactive gas for synthesizing carbon nanotubes onto the substrates conveyed by the conveyer belt, a substrate heating unit for heating the substrates loaded on the conveyer belt, for thermal reaction of the reactive gas, and an exhausting unit for exhausting a reaction product gas.

The reactive gas supplying unit includes a first reactive gas supplying unit for supplying a first reactive gas to the substrates loaded on the conveyer belt, and a second reactive gas supplying unit installed behind the first reactive gas supplying unit for supplying a second reactive gas onto the substrates conveyed by the conveyer belt after the first reactive gas has reacted.

The substrate heating unit heats a region of the conveyer belt facing the first reactive gas supplying unit to a temperature between about 700°C and 1100°C and a region of the conveyer belt facing the second reactive gas supplying unit to a temperature between about 500°C and 1100°C.

A transition metal layer used as a catalyst is included on the surface of each substrate, and the first reactive gas is an ammonia gas for etching the transition metal layer into fine grains, and the second reactive gas is a carbonized gas such as an acetylene gas, a methane gas, a propane gas, or an ethylene gas, or a gas in which an ammonia gas or a hydrogen gas are mixed with a carbonized gas.

The apparatus further includes a reactive gas heating unit installed around the reactive gas supplying unit for heating the reactive gas passing the reactive gas supplying unit. In this case, a first reactive gas heating unit of the reactive gas heating unit heats the reactive gas passing through the first reactive gas supplying unit to a temperature between about 700°C and 1100°C, and a second reactive gas heating unit of the reactive gas supplying unit heats the reactive gas passing the second reactive gas supplying unit to a temperature between about 500°C and 1100°C, and the substrate heating unit heats the substrates loaded on the conveyer belt to a temperature between about 400°C and 600°C.

According to the present invention, carbon nanotubes can be sequentially synthesized and grown on a plurality of large-sized substrates.

### BRIEF DESCRIPTION OF THE DRAWINGS

The above features and advantages of the present invention will become more apparent by describing in detail preferred embodiments thereof with reference to the attached drawings in which:
FIG. 1 is a schematic diagram illustrating a thermal chemical vapor deposition apparatus used in synthesizing carbon nanotubes according to a first embodiment of the present invention; and
FIG. 2 is a schematic diagram illustrating a thermal chemical vapor deposition apparatus used in synthesizing carbon nanotubes according to a second embodiment of the present invention.

### DETAILED DESCRIPTION OF THE INVENTION

The present invention will be described more fully hereinafter with reference to the accompanying drawings in which preferred embodiments of the invention are shown. This invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the forms of elements are exaggerated for clarity. Like reference numerals refer to like elements throughout the drawings.

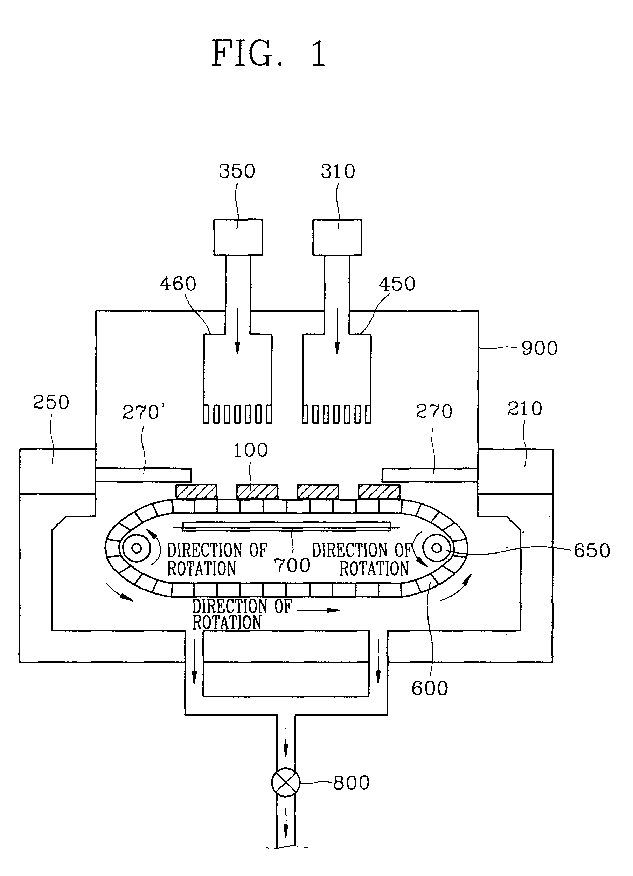

Referring to FIG. 1, the thermal chemical vapor deposition apparatus according to a first embodiment of the present invention includes a conveying conveyer belt 600 for loading a plurality of large-sized substrates 100. A plurality of large-sized plates may be connected to form the conveyer belt 600. The conveyer belt 600 conveys the loaded substrates 100 under the power of a rotating unit 650 such as a rotating axis connected to a motor.

A loading unit 210 is installed near at one end of the conveyer belt 600. A robot arm 270 sequentially loads the substrates 100 on the conveying conveyer belt 600. A unloading unit 250 is installed near at the other end of the conveyer belt 600. A robot arm 270' in the unloading unit 250 sequentially unloads the substrates 100 which are loaded onto the conveyer belt 600 and conveyed.

Reactive gas supplying units 450 and 460 for supplying a reactive gas used in synthesizing carbon nanotubes onto the substrates 100, which are loaded onto the conveyer belt 600 by the loading unit 210 and conveyed, are installed to face the conveyed substrates 100. Each of the reactive gas supplying units 450 and 460, which may be nozzles, supplies the reactive gas omto the substrates 100 conveyed on the conveyer belt 600.

A number of the reactive gas supplying units 450 and 460 required to synthesize the carbon nanotubes are prepared. For example, a first reactive gas supplying unit 450 is first installed, and a second reactive gas supplying unit 460 is installed behind the first reactive gas supplying unit 450, and a first reactive gas vessel 310 is connected to the first reactive gas supplying unit 450, and a second reactive gas vessel 350? is connected to the second reactive gas supplying unit 460. As a result, the first reactive gas can be supplied onto the substrates 100 conveyed on the conveyer belt 600 when the substrates 100 pass under a region at which the first reactive gas supplying unit 450 is installed, and the second reactive gas can be supplied onto the substrates 100 conveyed on the conveyer belt 600 when the substrates 100 pass under a region at which the second reactive gas supplying unit 460 is installed.

Meanwhile, a substrate heating unit 700 for heating the substrates 100 or a region adjacent to the substrates 100 is installed behind the conveyer belt 600 for tranferring the substrates 100. The substrate heating unit 700 provides thermal budgets where the reactive gas supplied onto the conveyed substrates 100 reacts on the substrates 100. The substrate heating unit 700 can heat the substrates 100 at different temperatures according to regions of the conveyer belt 600. For example, the substrate heating unit 700 heats a region facing the first reactive gas supplying unit 450 to a temperature between about 700°C and 1100°C and a region facing the second reactive gas supplying unit 460 to a temperature between about 500°C and 1100°C. The temperature conditions will be described in detail later, but the temperature corresponds to the temperature required to synthesize carbon nanotubes.

Meanwhile, a fan 800 is installed under the conveyer belt 600 as an exhausting unit for exhausting a reactive gas used in synthesizing or growing the carbon nanotubes on the substrates 100. The conveyer belt 600, the reactive gas supplying units 450 and 460 are installed in a chamber 900, and the chamber 900 is maintained at or below atmospheric pressure. However, for the convenience of processes, the chamber 900 can be maintained at atmospheric pressure.

Operation of the thermal chemical vapor deposition apparatus according to the first embodiment of the present invention and method of using the same will be described in greater detail by describing a method of synthesizing carbon nanotubes on the substrates 100.

Referring back to FIG. 1, each of the large-sized substrates 100 may be prepared to include a transition metal layer (not shown) on its surface. The transition metal layer is used as a catalyst in the synthesis of carbon nanotubes. The transition metal layer can be formed by thermal deposition or sputtering, or ion beam deposition, and its thickness is about 3nm through 200nm, preferably, about 3nm through 50nm. Here, the transition metal layer is formed of cobalt (Co), nickel (Ni), iron (Fe), yttrium (Y), cobalt(Co)-nickel (Ni) alloy, cobalt (Co)-iron (Fe) alloy, nickel (Ni)-iron (Fe) alloy, cobalt (Co)-nickel (Ni)-iron (Fe) alloy, cobalt (Co)-nickel (Ni)-yttrium (Y)-alloy, or cobalt (Co)-yttrium (Y) alloy.

Meanwhile, the substrates 100 are formed of various materials as occasion demands. For example, the substrates 100 may be formed of glass, alumina or silicon, with large size. The substrates 100 are loaded onto the loading unit 210. The substrates 200 are sequentially loaded onto the conveying conveyer belt 600 by the robot arm 270 of the loading unit 210 . The substrates 100 are conveyed by the conveyer belt 600.

Meanwhile, the first reactive gas supplying unit 450 supplies an ammonia gas from the first reactive gas vessel 310 to the substrates 100 conveyed past under the first reactive gas supplying unit 450. The ammonia gas is used in etching the transition metal layer being on the substrates 100. Here, a hydrogen gas can be supplied onto the substrates 100 instead of ammonia gas.

As described above, the transition metal layer is etched into fine grains by the supplied ammonia gas. More specifically, a region under the first active gas supplying unit 450 or the substrates 100 passing under the first reactive gas supplying unit 450 are heated by the substrate heating unit 700 installed beneath the conveyer belt 600 to a temperature between about 700°C and 1100°C, preferably to a temperature between about 800°C and 900°C. The ammonia gas supplied to the heated region or the substrates 100 is thermally activated or decomposed, and thereby the transition metal layer is etched into fine grains. The ammonia gas between about 80sccm (standard cubic centimeter per minute) and 1000sccm can be supplied to the heated region or onto the substrates 100.

Thus, the fine grains of the transition metal layer remain on the surface of the substrates 100 passing the first reactive gas supplying unit 450. When the substrates 100 reach the region facing the second reactive gas supplying unit 460 by the conveyer belt 600, the second reactive gas, for example, a carbonized gas, is supplied onto the substrates 100. Since the region facing the second reactive gas supplying unit 460 is maintained at a temperature between about 500°C and 1100°C by the substrate heating unit 700, the carbonized gas is decomposed, and a carbon source is provided onto the substrates 100, and the carbon source is synthesized on the fine grains of the transition metal layer as carbon nanotubes. As a result, carbon nanotubes are synthesized and grown to be vertically arranged on the substrates 100.

Gas for supplying carbon such as an acetylene gas, a methane gas, a propane gas, or an ethylene gas is used as the carbonized gas, and the carbonized gas may be supplied at a flow rate between about 20sccm and 1000sccm to the heated region or the substrates 100 through the second reactive gas supplying unit 460. Also, the carbonized gas containing the ammonia gas or/and the hydrogen gas can be supplied from the second reactive gas supplying unit 460. Here, the mixture ratio of carbon gas : hydrogen gas or ammonia gas is about 1:1, 1:2, 1:3, or 1:4.

The substrates 100 on whose surface carbon nanotubes are synthesized are conveyed by the conveyer belt 600 and unloaded by the robot arm 270' of the adjacent unloading unit 250.

The large-sized substrates 100 are sequentially conveyed by the conveyer belt 600 to perform the processes described above. When the carbon nanotubes are synthesized using the thermal chemical vapor deposition apparatus according to the first embodiment of the present invention, the carbon nanotubes can be sequentially and consecutively synthesized on the large-sized substrates 100. That is, the vertically-arranged carbon nanotubes can be synthesized on the substrates 100 in a very short time.

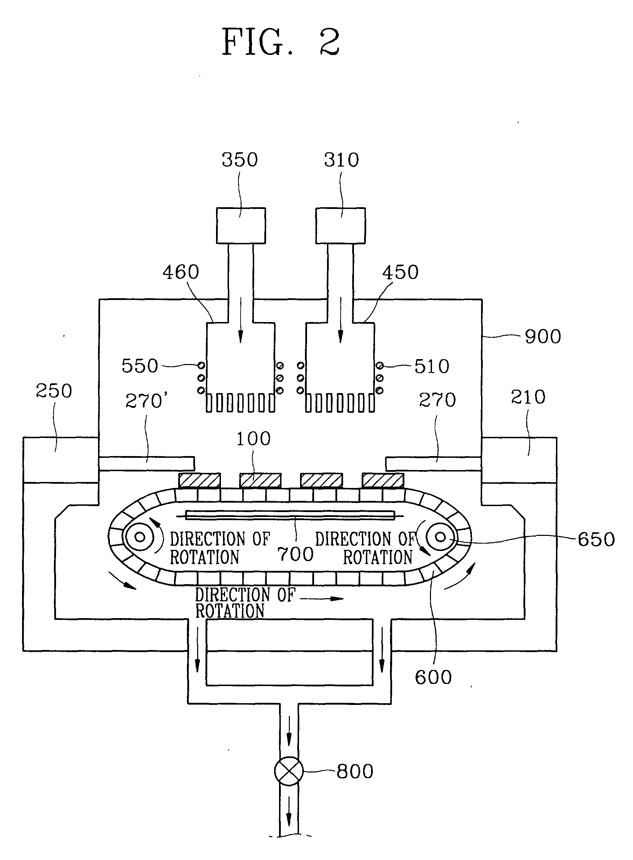

Referring to FIG. 2, in the thermal chemical vapor deposition apparatus according to a second embodiment of the present invention, a first reactive gas heating unit 510 is installed around a first reactive gas supplying unit 450 for example, around a nozzle, and a second reactive gas heating unit 550 is installed around a second reactive gas supplying unit 460. The reactive gas heating units 510 and 550 activate or decompose a reactive gas by heating the reactive gas passing through the reactive gas supplying units 450 and 460.

Operation of the apparatus of thermal chemical vapor deposition according to the second embodiment of the present invention and method of using the same will be described in greater detail by describing a method of synthesizing carbon nanotubes on the substrates 100.

Referring back to FIG. 2, as described in the first embodiment, the substrates 100 having a transition metal layer (not shown) on their surfaces are loaded onto the loading unit 210. Here, the large-sized substrates 100 could be formed of glass, or silicon, or alumina, as described previously. But, in the second embodiment, the substrates 100 are preferably formed of glass. In a case where glass is used as the large-sized substrates 100, the substrates 100 can be used in forming devices such as a field emitting device (FED), or a vacuum fluorescence display (VFD), or a white light source. That is, since the substrates 100 are formed of glass, a known vacuum sealing process for the display and devices can be applied.

However, when the substrates 100 are formed of glass, the melting point of the glass substrates 100, which are mainly used in a display, is low at about 550°C. As a result, as described in the first embodiment, in a case where the substrates 100 are heated by a substrate heating unit 700 to a temperature between about 700°C and 1100°C, the substrates 100 themselves melt.

In the second embodiment, in order to prevent the substrates 100 from melting, the substrate heating unit 700 installed under the conveyer belt 600 heats a region of the conveyer belt 600 or the substrates 100 passing the heated region to a temperature between about 500°C and 550°C. As a result, the glass substrates 100 do not melt during carbon nanotubes synthesis.

However, as described above, in order to thermally decompose ammonia gas used as an etching gas or an acetylene gas for providing a carbon source, the temperature must be about 700°C or over. For this purpose, in the second embodiment, the reactive gas heating units 510 and 550 are installed around the reactive gas supplying units 450 and 460.

That is, the first reactive gas heating unit 510 heats the first reactive gas passing through the first reactive gas supplying unit 450, for example, the ammonia gas or the hydrogen gas, to a temperature between about 700°C and 1100°C, preferably to a temperature of 800°C through 900°C. As a result, the ammonia gas is thermally decomposed, and the thermally-decomposed reactant is supplied onto the substrates 100 passing down through the first reactive gas supplying unit 450. Thermal decomposition of an etching gas such as the ammonia gas can occur in the first reactive gas supplying unit 450.

The thermally-decomposed ammonia gas, that is, the reactant etches a transition metal layer prepared on the substrates 100 and forms fine grains used as a catalyst on the surface of the substrates 100. Likewise, although the temperature around the substrates 100 is maintained at about 550°C, the thermally-decomposed ammonia gas, that is, the reactive gas, is supplied onto the substrates 100, and then, the etching of the transition metal layer can be performed.

The substrates 100 on the surfaces of which the fine grains are formed on, are conveyed to a region under the second reactive gas supplying unit 460 by the conveying conveyer belt 600. The thermally-decomposed second reactive gas, that is, the reactant, is supplied onto the substrates 100 through the second reactive gas supplying unit 460. For this purpose, the second reactive gas heating unit 550 installed around the second reactive gas supplying unit 460 heats the second reactive gas passing the second reactive gas supplying unit 460, for example, a carbonized gas such as an acetylene gas. Also, a mixture of the ammonia gas or/and the hydrogen gas with the carbonized gas can be supplied onto the substrates 100 through the second reactive gas supplying unit 460.

Here, the carbonized gas is heated to a temperature between about 500°C and 1100°C, preferably to a temperature of about 900°C, and can be thermally decomposed before the carbonized gas is out of the second reactive gas supplying unit 460. The carbonized gas can be supplied onto the substrates 100 at a flow rate of about 20sccm. Here, ammonia gas or/and the hydrogen gas may be further mixed with the carbonized gas. In this case, the mixture ratio of carbon gas : ammonia gas (or hydrogen gas) is about 1:1, 1:2, 1:3, or 1:4.

The thermally-decomposed acetylene gas is synthesized as carbon nanotubes by he fine grains of the transition metal layer acting as a catalyst formed on the substrates 100. Here, the substrates 100 are maintained at a temperature between about 500°C and 550°C by the substrate heating unit 700, and then, the carbon nanotubes synthesis can be fully performed.

Next, the substrates 100 on which the carbon nanotubes are synthesized and grown are conveyed by the conveyer belt 600 and unloaded by the robot arm 270' of the unloading unit 210.

The large-sized substrates 100 are sequentially conveyed by the conveying conveyer belt 600 to perform the processes described above. Also, when the carbon nanotubes are synthesized using the thermal chemical vapor deposition apparatus according to the second embodiment, the carbon nanotubes can be sequentially and consecutively synthesized on the large-sized substrates 100 without need of a high temperature of about 700°C. That is, a mass of vertically-arranged carbon nanotubes can be synthesized on the substrates 100, which are weak to heat like glass having a low melting point, in a very short time.

While this invention has been particularly shown and described with reference to preferred embodiments thereof, it will be understood by those skilled in the art that various changes in form and details may be made thereto without departing from the spirit and scope of the invention as defined by the appended claims.

## Claims

1. A thermal chemical vapor deposition apparatus comprising:
a conveyer belt for sequentially receiving and conveying a plurality of substrates;
a rotating unit for conveying the conveyer belt;
a loading unit for sequentially loading the substrates onto the conveyer belt;
an unloading unit installed to face the loading unit for unloading the substrates conveyed by the conveyer belt;
a reactive gas supplying unit for supplying a reactive gas for synthesizing carbon nanotubes onto the substrates conveyed by the conveyer belt;
a substrate heating unit for heating the substrates loaded on the conveyer belt, for thermal reaction of the reactive gas; and
an exhausting unit for exhausting a reaction product gas.

2. The apparatus according to claim 1, wherein the reactive gas supplying unit comprises;
a first reactive gas supplying unit for supplying a first reactive gas onto the substrates loaded on the conveyer belt; and
a second reactive gas supplying unit installed behind the first reactive gas supplying unit for supplying a second reactive gas onto the substrates conveyed by the conveyer belt after the first reactive gas is reacted.

3. The apparatus according to claim 2, wherein the substrate heating unit heats a region of the conveyer belt facing the first reactive gas supplying unit to a temperature between about 700°C and 1100°C, and
the substrate heating unit heats a region of the conveyer belt facing the second reactive gas supplying unit to a temperature between about 500°C and 1100°C.

4. The apparatus according to claim 2, wherein the substrates include a transition metal layer used as a catalyst on the surface of the substrate,
the first reactive gas is an ammonia gas for etching the transition metal layer into fine grains, and
the second reactive gas is a carbonized gas such as an acetylene gas, a methane gas, a propane gas, or an ethylene gas, or a gas in which an ammonia gas or a hydrogen gas are mixed with a carbonized gas.

5. The apparatus according to claim 1, wherein the loading unit and the unloading unit include a robot arm for picking up substrates.

6. A thermal chemical vapor deposition apparatus comprising:
a conveyer belt for sequentially receiving and conveying a plurality of substrates;
a rotating unit for conveying the conveyer belt;
a loading unit for sequentially loading the substrates onto the conveyer belt;
an unloading unit installed to face the loading unit for unloading the substrates conveyed by the conveyer belt;
a reactive gas supplying unit for supplying a reactive gas for synthesizing carbon nanotubes onto the substrates conveyed by the conveyer belt;
a reactive gas heating unit installed around the reactive gas supplying unit for heating the reactive gas passing through the reactive gas supplying unit;
a substrate heating unit for heating the substrates loaded on the conveyer belt; and
an exhausting unit for exhausting a reaction product gas.

7. The apparatus according to claim 6, wherein the reactive gas supplying unit comprises;
a first reactive gas supplying unit for supplying a first reactive gas onto the substrates loaded on the conveyer belt; and
a second reactive gas supplying unit installed behind the first reactive gas supplying unit for supplying a second reactive gas onto the substrates conveyed by the conveyer belt after the first reactive gas is reacted.

8. The apparatus according to claim 7, wherein the reactive gas heating unit comprises;
a first reactive gas heating unit installed around the first reactive gas supplying unit; and
a second reactive gas heating unit installed around the second reactive gas supplying unit.

9. The apparatus according to claim 8, wherein the first reactive gas heating unit heats the reactive gas passing through the first reactive gas supplying unit to a temperature between about 700°C and 1100°C, and
the second reactive gas heating unit heats the reactive gas passing through the second reactive gas supplying unit to a temperature between about 500°C and 1100°C, and
the substrate heating unit heats the substrates loaded on the conveyer belt to a temperature between about 400°C and 600°C.

10. The apparatus according to claim 7, wherein the substrates include a transition metal layer used as a catalyst on the surface of the substrate,
the first reactive gas is an ammonia gas for etching the transition metal layer into fine grains, and
the second reactive gas is a carbonized gas such as an acetylene gas, a methane gas, a propane gas, or an ethylene gas, or a gas in which an ammonia gas or a hydrogen gas are mixed with a carbonized gas.

11. A method of synthesizing carbon nanaotubes comprising the steps of:
sequentially loading a plurality of substrates onto a conveyer conveyer belt by a loading unit;
conveying the conveyer belt by a rotating unit and sequentially conveying the loaded substrates;
heating the substrates loaded onto the conveyer belt by a heating unit, supplying a reactive gas from a reactive gas supplying unit onto the conveyed substrates, and synthesizing carbon nanotubes on the conveyed substrates; and
sequentially unloading the substrates on which the carbon nanotubes are synthesized, by an unloading unit installed to face the loading unit.

12. The method according to claim 11, further comprising the step of forming a transition metal layer to be used as a catalyst on the substrates.

13. The method according to claim 11, wherein the transition metal layer is formed of cobalt (Co), nickel (Ni), iron (Fe), yttrium (Y), cobalt(Co)-nickel (Ni) alloy, cobalt (Co)-iron (Fe) alloy, nickel (Ni)-iron (Fe) alloy, cobalt (Co)-nickel (Ni)-iron (Fe) alloy, cobalt (Co)-nickel (Ni)-yttrium (Y)-alloy, or cobalt (Co)-yttrium (Y) alloy.

14. The method according to claim 11, wherein the step of synthesizing carbon nanotubes comprises the steps of:
supplying a first reactive gas onto the conveyed substrates through a first reactive gas supplying unit of the reactive gas supplying unit and etching the transition metal layer into fine grains; and
supplying a second reactive carbonized gas for synthesizing carbon nanotubes onto the substrates conveyed by the conveyer conveyer belt, through a second reactive gas supplying unit of the reactive gas supplying unit, after supply of the first reactive gas.

15. The method according to claim 14, wherein
the first reactive gas is an ammonia gas, and
the second reactive gas is a carbonized gas such as an acetylene gas, a methane gas, a propane gas, or an ethylene gas, or a gas in which an ammonia gas or a hydrogen gas are mixed with a carbonized gas.

16. The method according to claim 14, wherein a region of the conveyer belt to which the first reactive gas is supplied is heated to a temperature between about 700°C and 1100°C by the heating unit, and
a region of the conveyer belt to which the second reactive gas is supplied is heated to a temperature between about 500°C and 1100°C by the heating unit.

17. A method of synthesizing carbon nanaotubes comprising the steps of:
sequentially loading a plurality of substrates onto a conveyer conveyer belt by a loading unit;
conveying the conveyer belt by a rotating unit and sequentially conveying the loaded substrates;
heating the substrates loaded onto the conveyer belt by a heating unit, supplying a reactive gas, which passes through a reactive gas supplying unit and is heated by a reactive gas heating unit installed around the reactive gas supplying unit, onto the conveyed substrates, and synthesizing carbon nanotubes on the conveyed substrates; and
sequentially unloading the substrates in which the carbon nanotubes are synthesized, by an unloading unit installed to face the loading unit.

18. The method according to claim 17, further comprising the step of forming a transition metal layer to be used as a catalyst on the substrates.

19. The method according to claim 18, wherein the step of synthesizing carbon nanotubes comprises the steps of:
supplying a first reactive gas, which is heated by a first reactive gas heating unit of the reactive gas heating unit installed around a first reactive gas supplying unit of the reactive gas supplying unit, onto the conveyed substrates through the first reactive gas supplying unit and etching the transition metal layer into fine grains; and
supplying a second reactive carbonized gas for synthesizing carbon nanotubes, which is heated by a second reactive gas heating unit of the reactive gas heating unit installed around a second reactive gas supplying unit of the reactive gas supplying unit, onto the substrates conveyed by the conveyer conveyer belt through the second reactive gas supplying unit, after supply of the first reactive gas.

20. The method according to claim 19, wherein the first reactive gas heating unit heats reactive gas passing through the first reactive gas supplying unit to a temperature between about 700°C and 1100°C, and
the second reactive gas heating unit heats the reactive gas passing through the second reactive gas supplying unit to a temperature between about 500°C and 1100°C, and
the substrate heating unit heats the substrates loaded on the conveyer belt to a temperature between about 400°C and 600°C.
